# FASCICULE DE BREVET EUROPEEN

(11) **EP 3 050 107 B1**
(45) Date de publication et mention de la délivrance du brevet: **10.10.2018**
(21) Numéro de dépôt: 14771547.8
(22) Date de dépôt: 17.09.2014
(51) Int. Cl.: H01L 27/146, H04N 5/374

(54) **PIXEL D'UN IMAGEUR CMOS DE DÉTECTEUR OPTIQUE**
PIXEL EINES CMOS-BILDGEBERS EINES OPTISCHEN DETEKTORS
PIXEL OF A CMOS IMAGER OF AN OPTICAL DETECTOR

(30) Priorité: 27.09.2013 FR 1302261
(43) Date de publication de la demande: 03.08.2016
(73) Titulaire: Thales, 92200 Neuilly Sur Seine (FR); Commissariat à l'Energie Atomique et aux Energies Alternatives, 75015 Paris (FR)
(72) Inventeur: REVERCHON, Jean-Luc Raymond, F-91767 Palaiseau Cedex (FR); BELHAIRE, Eric, F-78995 Elancourt Cedex (FR); BOIS, Philippe, F-91767 Palaiseau Cedex (FR)
(74) Mandataire: Lavoix
(86) Numéro de dépôt international: PCT/EP2014/069803
(87) Numéro de publication internationale: WO 2015/044014

(56) Documents cités:
- WO-A2-2006/073875
- FR-A1- 2 966 976
- FR-A1- 2 966 978
- US-A1- 2010 072 349

## Description

La présente invention concerne un pixel d'un imageur CMOS, un imageur CMOS comprenant au moins un tel pixel et une caméra comportant un tel imageur.

De nombreuses applications dans le domaine de la sécurité impliquent une détection de faisceaux lumineux présentant de faibles niveaux de lumière, typiquement entre 1 µLux et 1 mLux. Il est donc souhaitable de disposer de détecteurs permettant la détection de faibles niveaux de lumière une gamme spectrale étendue permettant également d'autres fonctionnalités de type détection de tache laser ou de points chauds.

Pour cela, il est notamment connu de l'état de la technique de disposer de deux circuits de détection différents, un pour une première gamme spectrale, par exemple le visible, et l'autre pour la deuxième gamme spectrale, par exemple l'infrarouge. Pour le circuit associé à la deuxième gamme spectrale, selon un schéma électrique connu, une photodiode infrarouge est connectée directement en entrée d'un circuit de lecture à trois transistors. Le circuit de lecture à trois transistors sert à lire et à convertir le courant produit par la photodiode infrarouge.

Le document FR 2 966 978 décrit un détecteur de rayonnement visible et proche infrarouge. Toutefois, ce circuit présente un bruit de lecture important.

Un but de l'invention est donc de proposer un pixel d'imageur permettant de réduire le bruit de lecture en utilisant comme circuit de lecture la structure de base des imageurs CMOS visibles les plus performants.

A cet effet, l'invention a pour objet un pixel d'un imageur, le pixel comprenant une photodiode infrarouge adaptée pour générer un courant électrique lorsqu'elle est exposée à un rayonnement optique ayant une longueur d'onde supérieure à 950 nanomètres (nm), un circuit de conversion propre à recevoir des électrons et à délivrer une tension de valeur variable en fonction du nombre d'électrons reçus et un premier interrupteur connecté entre la photodiode infrarouge et le circuit de conversion.

Suivant d'autres modes de réalisation, le pixel comprend une ou plusieurs des caractéristiques suivantes, prise(s) isolément ou suivant toutes les combinaisons techniquement possibles :
- la photodiode infrarouge est dépourvue de silicium.
- la photodiode infrarouge est faite à partir d'un semi-conducteur à base de matériaux des colonnes IIIA et VA de la classification périodique.
- le pixel comprend, en outre, un réservoir d'électrons connecté entre la photodiode infrarouge et le premier interrupteur et un premier noeud de diffusion connecté entre le premier interrupteur et le circuit de conversion, le premier interrupteur étant mobile entre une position ouverte et une position fermée, le réservoir et le premier noeud de diffusion étant reliés dans la position fermée.

- le réservoir est choisi parmi un groupe constitué d'un deuxième noeud de diffusion, et d'une photodiode enterrée.
- la photodiode infrarouge comprend deux électrodes, l'une des deux électrodes étant connectée au réservoir.
- le réservoir est une photodiode enterrée et l'imageur comporte, en outre, un deuxième interrupteur connecté entre la photodiode infrarouge et la photodiode enterrée.
- le pixel comporte, en outre, un deuxième noeud de diffusion connecté entre la photodiode infrarouge et le deuxième interrupteur, le deuxième interrupteur étant mobile entre une position ouverte et une position fermée, le réservoir et le deuxième noeud de diffusion étant reliés dans la position fermée.
- la photodiode infrarouge comprend deux électrodes et le premier interrupteur comporte une entrée de contrôle du premier interrupteur, l'une des deux électrodes de la photodiode infrarouge étant connectée à l'entrée de contrôle du premier interrupteur.

Il est également proposé un imageur CMOS comportant une pluralité de pixels, au moins l'un des pixels étant tel que décrit précédemment.

L'invention concerne aussi un imageur CMOS comportant une pluralité de pixels, chaque pixel étant tel que décrit précédemment.

Il est également proposé une caméra comprenant au moins un imageur CMOS tel que précédemment décrit.

Il est également proposé un pixel d'un imageur CMOS, le pixel comprenant :
- une photodiode infrarouge adaptée pour générer un courant électrique lorsqu'elle est exposée à un rayonnement optique ayant une longueur d'onde supérieure à 950 nanomètres (nm),
- un circuit de conversion propre à recevoir des électrons et à délivrer une tension de valeur variable en fonction du nombre d'électrons reçus,
caractérisé en ce que le pixel comprend, en outre :
- un premier interrupteur connecté entre la photodiode infrarouge et le circuit de
   conversion,
- un réservoir d'électrons,
- un premier noeud de diffusion connecté entre le premier interrupteur et le circuit de conversion,
- le premier interrupteur étant mobile entre une position ouverte et une position fermée, le réservoir et le premier noeud de diffusion étant reliés dans la position fermée,

le réservoir d'électrons étant une photodiode enterrée.

Suivant d'autres modes de réalisation, le pixel comprend une ou plusieurs des caractéristiques suivantes, prise(s) isolément ou suivant toutes les combinaisons techniquement possibles :
- la photodiode infrarouge est dépourvue de silicium.
- la photodiode infrarouge est faite à partir d'un semi-conducteur à base de matériaux des colonnes IIIA et VA de la classification périodique.
- la photodiode infrarouge comprend deux électrodes, l'une des deux électrodes étant connectée au réservoir.
- l'imageur comporte, en outre, un deuxième interrupteur connecté entre la photodiode infrarouge et la photodiode enterrée.
- le pixel comporte, en outre, un deuxième noeud de diffusion connecté entre la photodiode infrarouge et le deuxième interrupteur, le deuxième interrupteur étant mobile entre une position ouverte et une position fermée, le réservoir et le deuxième noeud de diffusion étant reliés dans la position fermée.
- la photodiode infrarouge comprend deux électrodes et le premier interrupteur comporte une entrée de contrôle du premier interrupteur, l'une des deux électrodes de la photodiode infrarouge étant connectée à l'entrée de contrôle du premier interrupteur.

D'autres caractéristiques et avantages de l'invention apparaîtront à la lecture de la description qui suit de modes de réalisation de l'invention, donnés uniquement à titre d'exemple non limitatifs et en référence aux dessins annexés sur lesquels :
- la figure 1 est une représentation schématique d'une caméra selon l'invention, la caméra comprenant un imageur comportant une pluralité de pixels ;
- la figure 2 est une représentation schématique d'un pixel de la figure 1 selon un premier mode de réalisation de l'invention, et
- les figures 3 à 9 sont des vues analogues à celles de la figure 2 selon un deuxième, troisième, quatrième, cinquième, sixième, septième et respectivement huitième mode de réalisation.

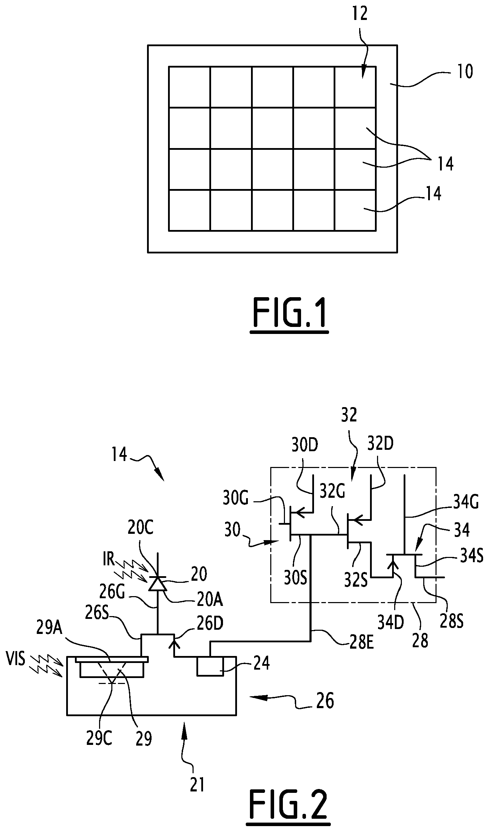

La caméra 10 représenté à la figure 1 est adaptée pour détecter un rayonnement optique dont la ou les longueurs d'ondes appartiennent à plusieurs gammes spectrales.

A titre d'illustration, les longueurs d'onde de la gamme spectrale de fonctionnement de la caméra 10 sont comprises dans les domaines visible et infrarouge. Par exemple, les longueurs d'onde de la gamme spectrale de fonctionnement sont comprises entre 400 nanomètres (nm) et 1,7 micromètres (µm).

La caméra 10 comprend un imageur 12 et un ou des éléments mécaniques permettant d'assurer le maintien et la protection de l'imageur 12.

En variante, la caméra 10 comporte également au moins un élément mécanique permettant de modifier la position de l'imageur 12 (cas des détecteurs 10 dédiés à une application de surveillance).

Selon encore une autre variante, la caméra 10 comprend une pluralité d'imageurs 12 superposés et des éléments mécaniques, par exemple de maintien, de protection ou de modification de position.

L'imageur 12 est propre à convertir une image optique en un signal électronique.

Dans le cas de l'invention, l'imageur 12 est un imageur CMOS. Il est entendu par l'expression « imageur CMOS », un imageur dont les composants sont des composants CMOS. Un composant CMOS est un composant fabriqué selon la technologie CMOS, l'acronyme CMOS renvoyant à la terminologie anglaise de « Complementary Metal Oxyde Semiconductor ».

L'imageur 12 comprend une matrice de pixels 14. Par exemple, l'imageur 12 comprend une matrice de 256 par 256 pixels 14, soit 65536 pixels 14.

En outre, selon l'exemple de la figure 1, chaque pixel 14 est identique. De ce fait, un seul pixel 14 est décrit dans la suite.

Selon un premier mode de réalisation représenté sur la figure 2, le pixel 14 comprend une photodiode infrarouge 20, un réservoir d'électrons 21, un premier noeud de diffusion 24 aussi appelé premier noeud de diffusion flottante 24, un premier interrupteur 26 également appelé interrupteur de transfert de charge 26 et un circuit de conversion 28 de charge en tension
La photodiode infrarouge 20 est adaptée pour générer un courant électrique lorsqu'elle est exposée à un rayonnement dont la longueur d'onde est supérieure à 950 nanomètres (nm). Le rayonnement est schématisé sur la figure 2 par deux flèches surmontées de l'indication IR.

De préférence, la photodiode infrarouge 20 est adaptée pour générer un courant électrique seulement lorsqu'elle est exposée à un rayonnement dont la longueur d'onde est comprise entre 950 nm et 1700 nm.

La photodiode infrarouge 20 est dépourvue de silicium. Elle est, par exemple, faite à partir d'un semi-conducteur à base de matériaux des colonnes IIIA et VA de la classification périodique.

Un semi-conducteur de type « III - V » est un semi-conducteur composite fabriqué à partir d'un ou plusieurs éléments de la colonne IIIA du tableau périodique des éléments (bore, aluminium, gallium, indium, ...) et d'un ou plusieurs éléments de la colonne VA ou pnictogènes (azote, phosphore, arsenic, antimoine ...).

A titre d'illustration, la photodiode infrarouge 20 est un assemblage de trois couches de phosphure d'indium (formule chimique InP), d'arséniure d'indium et de gallium (formule chimique InGaAs) et de phosphure d'indium (formule chimique InP).

En variante, la photodiode infrarouge 20 est faite à base de telluride de cadmium et de mercure (HgCdTe).

La photodiode infrarouge 20 comprend deux électrodes : une anode 20A et une cathode 20C.

Le réservoir d'électrons 21 est, dans l'exemple de la figure 2, une photodiode enterrée 29. La photodiode enterrée 29 comporte du silicium et est adaptée pour générer un courant électrique seulement lorsqu'elle est exposée à un rayonnement dont la longueur d'onde est comprise dans la bande visible (400 nm à 800 nm). La photodiode enterrée 29 comprend deux électrodes : une anode 29A et une cathode 29C.

Le noeud de diffusion 24 est, selon l'exemple de la figure 2, une couche dopée N.

L'interrupteur de transfert 26 est par exemple un transistor MOSFET (acronyme anglais de Metal Oxide Semiconductor Field Effect Transistor - qui se traduit par transistor à effet de champ à structure métal-oxyde-semiconducteur).

Un transistor MOSFET comprend une électrode de grille, une électrode de drain et une électrode de source, également appelées grille, drain et source. Dans la suite, les électrodes de grille, de drain et de source d'un transistor sont repérés respectivement par en accolant respectivement les lettres G, D et S au signe de référence du transistor.

La grille 26G de l'interrupteur de transfert 26 est reliée à l'anode 20A de la photodiode infrarouge 20 ; la source 26S de l'interrupteur de transfert 26 est reliée à l'anode 29A de la photodiode enterrée 29 et le drain 26D de l'interrupteur de transfert 26 est relié au premier noeud de diffusion 24.

L'interrupteur de transfert 26 est mobile entre une position ouverte et une position fermée. Dans la position fermée, la photodiode enterrée 29 et le premier noeud de diffusion 24 sont reliés.

Le circuit de conversion 28 comporte une entrée 28E et une sortie 28S.

L'entrée 28E est reliée au premier noeud de diffusion 24.

Le circuit de conversion 28 est propre à délivrer à la sortie 28S une tension de valeur variable en fonction d'un nombre d'électrons reçus à l'entrée 28E.

A titre d'exemple, le circuit de conversion 28 est un circuit dit « à trois transistors ».

Le circuit de conversion 28 comporte un transistor de remise à zéro 30, un transistor de sélection de ligne 32 et un transistor suiveur 34.

Chacun des trois transistors 30, 32, 34 est un transistor de type MOSFET.

La source 30S du transistor de remise à zéro 30 est reliée à l'entrée 28E du circuit de conversion 28 et à la grille 32G du transistor de sélection de ligne 32.

La source 32S du transistor de sélection de ligne 32 est reliée au drain 34D du transistor suiveur 34.

Le fonctionnement du pixel 14 visible sur la figure 2 est à présent décrit.

Un rayonnement optique dont la longueur d'onde est comprise entre 950 nm et 1700 nm illumine la photodiode infrarouge 20.

En réponse, la photodiode infrarouge 20 génère un courant électrique proportionnel à l'intensité du rayonnement optique reçu.

Le courant électrique généré est injecté au niveau de la grille 26G de l'interrupteur de transfert 26.

Lorsque l'interrupteur de transfert 26 reçoit un courant dont l'intensité est suffisante pour modifier sa position, l'interrupteur de transfert 26 est alors mis dans la position fermée. Dans cette position, la photodiode enterrée 29 et le premier noeud de diffusion 24 étant reliés, il se crée un transfert d'électrons depuis la photodiode enterrée 29 vers le premier noeud de diffusion 24.

La position de l'interrupteur de transfert 26 et donc le nombre d'électrons transférés vers le premier noeud de diffusion 24 dépend du courant électrique généré par la photodiode infrarouge 20.

Le premier noeud de diffusion 24 accumule ainsi des électrons en fonction de l'intensité du rayonnement optique reçu par la photodiode infrarouge 20.

Ces électrons accumulés sont ensuite convertis en tension par le circuit de conversion 28.

Un tel pixel 14 permet donc de lire et de convertir le courant de la photodiode infrarouge 20 en réponse au rayonnement optique dont la longueur d'onde est comprise entre 950 nm et 1700 nm.

En outre, de part la présence de l'interrupteur de transfert 26, les étapes de lecture et de conversion du signal de la photodiode infrarouge 20 sont successives dans le temps et pas simultanées.

Il en résulte que l'étape de lecture présente un bruit réduit par rapport à l'état de la technique. Ceci se traduit notamment par un courant d'obscurité réduit.

De plus, par rapport aux composants réalisés en technologie CCD (CCD pour *« Charge-Coupled Device* », ou dispositif à transfert de charge), un tel imageur CMOS 12 présente l'avantage de présenter des performances aussi bonnes avec un coût de fabrication moindre.

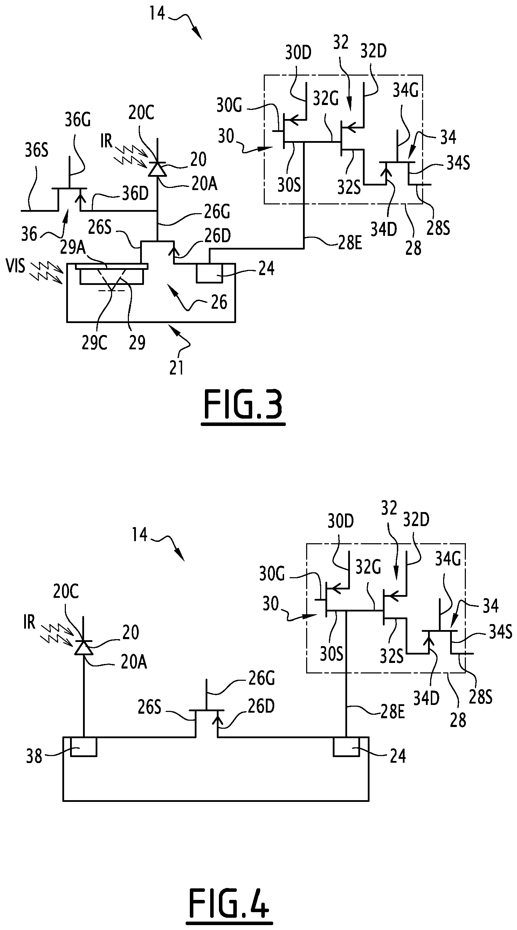

Selon un deuxième mode de réalisation tel que visible à la figure 3, le pixel 14 comprend les mêmes éléments que le pixel 14 selon le premier mode de réalisation décrit en regard de la figure 2.

Le pixel 14 comporte, en outre, un interrupteur de remise à zéro 36.

L'interrupteur de remise à zéro 36 est un transistor MOSFET.

Le drain 36D de l'interrupteur de remise à zéro 36 est relié à l'anode 20A de la photodiode infrarouge 20 et à la grille 26G de l'interrupteur de transfert 26.

Le fonctionnement du pixel 14 visible sur la figure 3 est similaire au fonctionnement du pixel 14 visible sur la figure 2.

En outre, l'interrupteur de remise à zéro 36 permet de remettre à zéro la photodiode infrarouge 20 pour reconditionner (c'est-à-dire réinitialiser) les conditions de transfert de charges de la photodiode visible vers le premier noeud de diffusion 24 avant la conversion des électrons accumulés en tension par le circuit de conversion 28.

Cela évite une accumulation parasite d'électrons dans la photodiode infrarouge 20 qui n'auraient pas été convertis en électrons accumulés dans le premier noeud de diffusion 24.

Selon un troisième mode de réalisation tel que visible à la figure 4, les éléments identiques au pixel 14 selon le premier mode de réalisation décrit en regard de la figure 2 ne sont pas répétés. Seules les différences sont mises en évidence.

Dans ce troisième mode de réalisation, le réservoir 21 est un deuxième noeud de diffusion 38 aussi appelé deuxième noeud de diffusion flottant 38 au lieu de la photodiode enterrée 29.

En outre, l'anode 20A de la photodiode infrarouge 20 est reliée au deuxième noeud de diffusion 38 au lieu d'être relié à la grille 26G de l'interrupteur 26 de transfert.

Le fonctionnement du pixel 14 visible sur la figure 4 est à présent décrit.

Un rayonnement optique dont la longueur d'onde est comprise entre 950 nm et 1700 nm illumine la photodiode infrarouge 20.

En réponse, la photodiode infrarouge 20 génère un courant électrique proportionnel à l'intensité du rayonnement optique reçu.

Le courant électrique généré est injecté au niveau du deuxième noeud de diffusion 38.

Des électrons s'accumulent dans le deuxième noeud de diffusion 38.

Puis, l'interrupteur de transfert 26 est mis dans la position fermée. Le deuxième noeud de diffusion 38 et le premier noeud de diffusion 24 étant alors reliés, il se crée alors un transfert d'électrons depuis le deuxième noeud de diffusion 38 vers le premier noeud de diffusion 24.

Le nombre d'électrons transférés vers le premier noeud de diffusion 24 dépend du courant électrique généré par la photodiode infrarouge 20.

Le premier noeud de diffusion 24 accumule ainsi des électrons en fonction de l'intensité du rayonnement optique reçu par la photodiode infrarouge 20.

Ces électrons accumulés sont ensuite convertis en tension par le circuit de conversion 28.

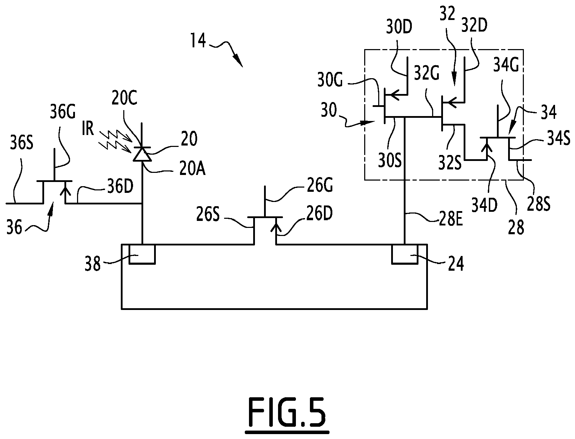

Selon un quatrième mode de réalisation tel que visible à la figure 5, le pixel 14 comprend les mêmes éléments que le pixel 14 selon le troisième mode de réalisation décrit en regard de la figure 4.

Le pixel 14 comporte, en outre, un interrupteur de remise à zéro 36.

L'interrupteur de remise à zéro 36 est un transistor MOSFET.

Le drain 36D de l'interrupteur de remise à zéro 36 est relié à l'anode 20A de la photodiode infrarouge 20 et au deuxième noeud de diffusion 38.

Le fonctionnement du pixel 14 visible sur la figure 5 est similaire au fonctionnement du pixel 14 visible sur la figure 4.

En outre, l'interrupteur de remise à zéro 36 permet de remettre à zéro la photodiode infrarouge 20 pour reconditionner (c'est-à-dire réinitialiser) les conditions de transfert de charges de la photodiode visible vers le premier noeud de diffusion 24 avant la conversion des électrons accumulés en tension par le circuit de conversion 28.

Cela évite une accumulation parasite d'électrons dans la photodiode infrarouge 20 qui n'auraient pas été convertis en électrons accumulés dans le premier noeud de diffusion 24.

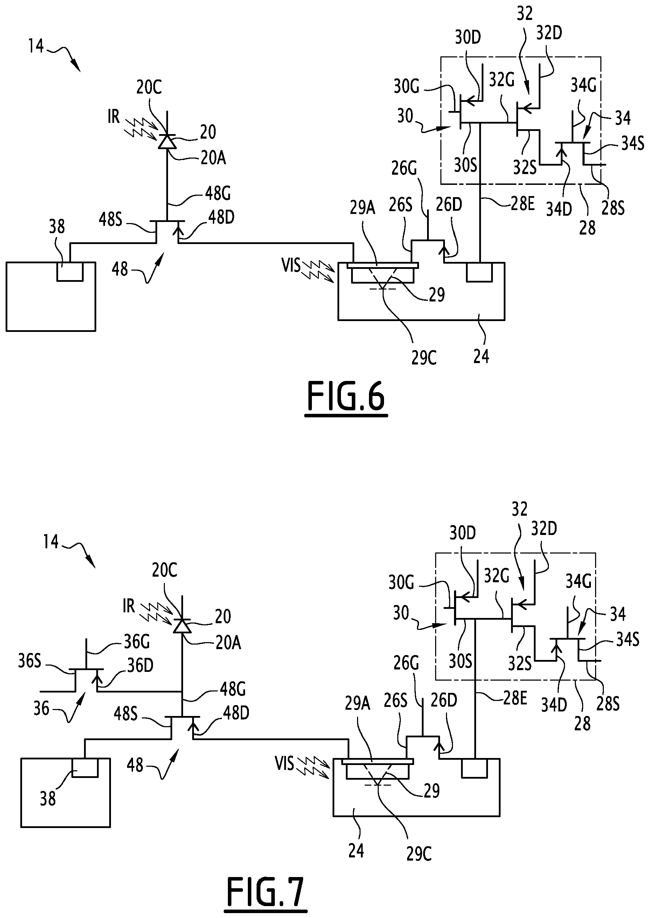

Selon un cinquième mode de réalisation tel que visible à la figure 6, les éléments identiques au pixel 14 selon le premier mode de réalisation de la figure 2 ne sont pas répétés. Seules les différences sont mises en évidence.

Dans ce cas, le pixel 14 comprend également un deuxième noeud de diffusion 38 et un deuxième interrupteur 48, également appelé interrupteur de drainage 48.

L'interrupteur de drainage 48 est un transistor MOSFET.

Le drain 48D de l'interrupteur de drainage 48 est relié à la photodiode enterrée 29 tandis que la source 48S de l'interrupteur de drainage 48 est reliée au deuxième noeud de diffusion 38.

L'interrupteur de drainage 48 est mobile entre une position ouverte et fermée. Dans la position fermée, la photodiode enterrée 29 et le deuxième noeud de diffusion 24 sont reliés.

En outre, l'anode 20A de la photodiode infrarouge 20 est reliée à la grille 48G de l'interrupteur de drainage 48.

Le fonctionnement du pixel 14 visible sur la figure 6 est à présent décrit.

Un rayonnement optique dont la longueur d'onde est comprise entre 950 nm et 1700 nm illumine la photodiode infrarouge 20.

En réponse, la photodiode infrarouge 20 génère un courant électrique proportionnel à l'intensité du rayonnement optique reçu.

Le courant électrique généré est injecté au niveau de la grille 48G de l'interrupteur de drainage 48.

Lorsque l'interrupteur de drainage 48 reçoit un courant dont l'intensité est suffisante pour modifier sa position, l'interrupteur de drainage 48 est mis dans la position fermée. Dans cette position, le deuxième noeud de diffusion 38 et le photodiode enterrée 29 étant reliés, il se crée un transfert d'électrons depuis le deuxième noeud de diffusion 38 vers la photodiode enterrée 29.

La position de l'interrupteur de drainage 48 et donc le nombre d'électrons transférés vers la photodiode enterrée 29 dépend du courant électrique généré par la photodiode infrarouge 20.

La photodiode enterrée 29 accumule ainsi des électrons en fonction de l'intensité du rayonnement optique reçu par la photodiode infrarouge 20.

Puis, l'interrupteur de transfert 26 est mis dans la position de fonctionnement dans laquelle la photodiode enterrée 29 et le premier noeud de diffusion 24 sont couplés. Les électrons accumulés dans la photodiode enterrée 29 sont transférés vers le premier noeud de diffusion 24 puis convertis en tension par le circuit de conversion 28.

Selon un sixième mode de réalisation tel que visible à la figure 7, le pixel 14 comprend les mêmes éléments que le pixel 14 de la figure 6.

Le pixel 14 comporte, en outre, un interrupteur de remise à zéro 36.

L'interrupteur de remise à zéro 36 est un transistor MOSFET.

Le drain 36D de l'interrupteur de remise à zéro 36 est relié à l'anode 20A de la photodiode infrarouge 20 et à la grille 48G de l'interrupteur de drainage 48.

Le fonctionnement du pixel 14 visible sur la figure 7 est similaire au fonctionnement du pixel 14 visible sur la figure 6.

De plus, l'interrupteur de remise à zéro 36 permet de remettre à zéro la photodiode infrarouge 20 lorsque les électrons accumulés dans la photodiode enterrée 29 sont convertis en tension par le circuit de conversion 28.

Cela évite une accumulation parasite d'électrons dans la photodiode infrarouge 20 qui n'auraient pas été convertis en électrons accumulés dans la photodiode enterrée 29.

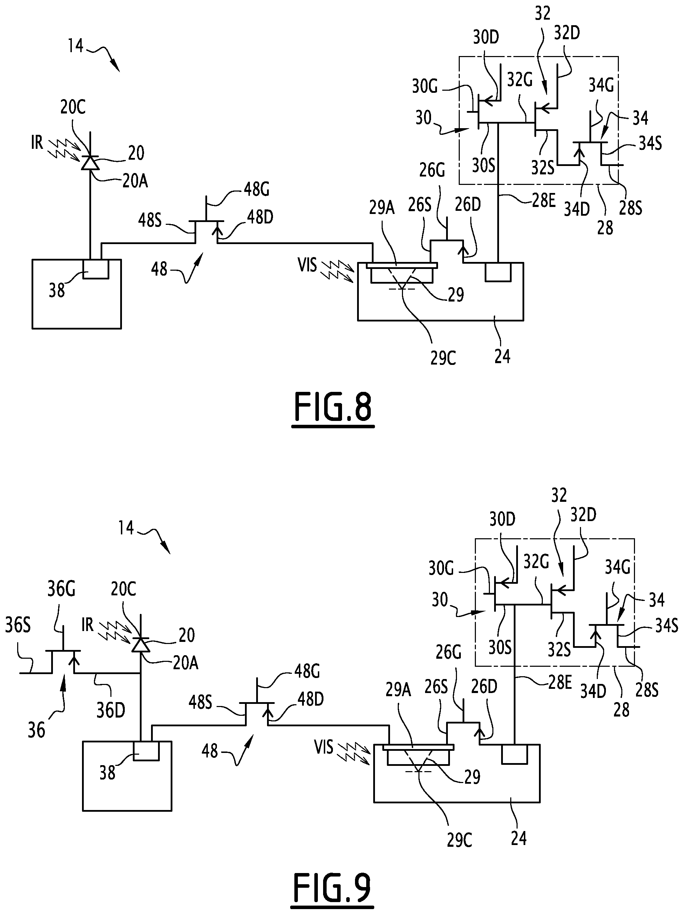

Selon un septième mode de réalisation tel que visible à la figure 8, les éléments identiques au pixel 14 selon le cinquième mode de réalisation de la figure 6 ne sont pas répétés. Seules les différences sont mises en évidence.

Dans ce septième mode de réalisation, l'anode 20A de la photodiode infrarouge 20 est reliée au deuxième noeud de diffusion 38 au lieu d'être reliée à la grille 48G de l'interrupteur de drainage 48.

Le fonctionnement du pixel 14 visible sur la figure 8 est à présent décrit.

Un rayonnement optique dont la longueur d'onde est comprise entre 950 nm et 1700 nm illumine la photodiode infrarouge 20.

En réponse, la photodiode infrarouge 20 génère un courant électrique proportionnel à l'intensité du rayonnement optique reçu.

Le courant électrique généré est injecté au niveau du deuxième noeud de diffusion 38.

Des électrons s'accumulent dans le deuxième noeud de diffusion 38.

Puis, l'interrupteur de drainage 48 est mis dans la position fermée. Il se crée alors un transfert d'électrons depuis le deuxième noeud de diffusion38 vers la photodiode enterrée 29.

Le nombre d'électrons transférés vers la photodiode enterrée 29 dépend ainsi du courant électrique généré par la photodiode infrarouge 20.

L'interrupteur de drainage 26 est ensuite mis dans la position fermée. Le premier noeud de diffusion 24 et la photodiode enterrée 29 étant reliés, il se crée alors un transfert d'électrons depuis la photodiode enterrée 29 vers le premier noeud de diffusion 24.

Le nombre d'électrons transférés vers le premier noeud de diffusion 42 dépend du courant électrique généré par la photodiode infrarouge 20.

Le premier noeud de diffusion 24 accumule ainsi des électrons en fonction de l'intensité du rayonnement optique reçu par la photodiode infrarouge 20.

Ces électrons accumulés sont ensuite convertis en tension par le circuit de conversion 28.

Selon un huitième mode de réalisation tel que visible à la figure 9, le pixel 14 comprend les mêmes éléments que le pixel 14 selon le septième mode de réalisation décrit en regard de la figure 7.

Le pixel 14 comporte, en outre, un interrupteur de remise à zéro 36.

L'interrupteur de remise à zéro 36 est un transistor MOSFET.

Le drain 36D de l'interrupteur de remise à zéro 36 est relié à l'anode 20A de la photodiode infrarouge 20 et au deuxième noeud de diffusion 38.

Le fonctionnement du pixel 14 visible sur la figure 9 est similaire au fonctionnement du pixel 14 visible sur la figure 8.

En outre, l'interrupteur de remise à zéro 36 permet de remettre à zéro la photodiode infrarouge 20 pour reconditionner (c'est-à-dire réinitialiser) les conditions de transfert de charges de la photodiode visible vers le premier noeud de diffusion 24 avant la conversion des électrons accumulés en tension par le circuit de conversion 28.

Cela évite une accumulation parasite d'électrons dans la photodiode infrarouge 20 qui n'auraient pas été convertis en électrons accumulés dans le premier noeud de diffusion 24.Dans tous les modes de réalisations présentés, l'interrupteur de transfert 26 est connecté entre la photodiode infrarouge 20 et le circuit de conversion 28. Cela permet d'assurer une séparation entre la fonction de lecture du courant généré par la photodiode infrarouge 20 et la fonction de conversion du courant généré par la photodiode infrarouge 20. Cette séparation résulte en une diminution du bruit présent durant la fonction de lecture. Des performances de bruit aussi basses que quelques électrons peuvent être obtenues.

En outre, pour tous les modes de réalisation, il est possible également en variante d'utiliser la photodiode infrarouge 20 dans la polarité inverse. A titre d'exemple, dans la variante associée au premier mode de réalisation, cela signifie que la cathode 20C est
connectée à la grille 26G de l'interrupteur de drainage 26 au lieu de l'anode 20A.

## Revendications

1. Pixel (14) d'un imageur CMOS, le pixel (14) comprenant :
- une photodiode infrarouge (20) adaptée pour générer un courant électrique lorsqu'elle est exposée à un rayonnement optique ayant une longueur d'onde supérieure à 950 nanomètres (nm),
- un circuit de conversion (28) propre à recevoir des électrons et à délivrer une tension de valeur variable en fonction du nombre d'électrons reçus,
- un premier interrupteur (26) connecté entre la photodiode infrarouge (20) et le circuit de conversion (28),
- un réservoir d'électrons (21), le réservoir d'électrons (21) étant une photodiode enterrée (29),
- un premier noeud de diffusion (24) connecté entre le premier interrupteur (26) et le circuit de conversion (28), **caractérisé en ce que**
- le premier interrupteur (26) étant mobile entre une position ouverte et une position fermée, le réservoir (21) et le premier noeud de diffusion (24) étant reliés dans la position fermée.

2. Pixel selon la revendication 1, dans lequel la photodiode infrarouge (20) est dépourvue de silicium.

3. Pixel selon la revendication 1 ou 2, dans lequel la photodiode infrarouge (20) est faite à partir d'un semi-conducteur à base de matériaux des colonnes IIIA et VA de la classification périodique.

4. Pixel selon l'une quelconque des revendications 1 à 3, dans lequel la photodiode infrarouge (20) comprend deux électrodes (20A, 20C), l'une des deux électrodes (20A, 20C) étant connectée au réservoir (21).

5. Pixel selon l'une quelconque des revendications 1 à 4, dans lequel l'imageur (12) comporte, en outre :
- un deuxième interrupteur (48) connecté entre la photodiode infrarouge (20) et la photodiode enterrée (29).

6. Pixel selon la revendication 5, dans lequel le pixel (14) comporte, en outre :
- un deuxième noeud de diffusion (38) connecté entre la photodiode infrarouge (20) et le deuxième interrupteur (48),
le deuxième interrupteur (48) étant mobile entre une position ouverte et une position fermée, le réservoir (21) et le deuxième noeud de diffusion (38) étant reliés dans la position fermée.

7. Pixel selon l'une quelconque des revendications 1 à 3, dans lequel la photodiode infrarouge (20) comprend deux électrodes (20A, 20C) et le premier interrupteur (26) comporte une entrée de contrôle (26G) du premier interrupteur (26), l'une des deux électrodes (20A, 20C) de la photodiode infrarouge (20) étant connectée à l'entrée de contrôle (26G) du premier interrupteur (26).

8. Imageur CMOS (12) comportant une pluralité de pixels (14), au moins l'un des pixels (14) étant selon l'une quelconque des revendications 1 à 7.

9. Imageur CMOS (12) comportant une pluralité de pixels (14), chaque pixel (14) étant selon l'une quelconque des revendications 1 à 7.

10. Caméra (10) comprenant au moins un imageur CMOS (12) selon la revendication 8 ou 9.

## Patentansprüche

1. Pixel (14) eines CMOS-Bildgebers, wobei das Pixel (14) umfasst:
- eine Infrarotphotodiode (20), die angepasst ist, um einen elektrischen Strom zu erzeugen, wenn sie einer optischen Strahlung ausgesetzt ist, die eine Wellenlänge von mehr als 950 Nanometern (nm) aufweist,
- eine Umwandlungsschaltung (28), die geeignet ist, Elektronen zu empfangen und eine Spannung abzugeben, deren Wert in Abhängigkeit von der Anzahl der empfangenen Elektronen variiert,
- einen ersten Schalter (26), der zwischen der Infrarotphotodiode (20) und der Umwandlungsschaltung (28) angeschlossen ist,
- ein Elektronenreservoir (21), wobei das Elektronenreservoir (21) eine eingebettete Photodiode (29) ist,
- einen ersten Diffusionsknoten (24), der zwischen dem ersten Schalter (26) und der Umwandlungsschaltung (28) angeschlossen ist,
**dadurch gekennzeichnet, dass**
- der erste Schalter (26) zwischen einer offenen Position und einer geschlossenen Position bewegbar ist, wobei das Reservoir (21) und der erste Diffusionsknoten (24) in der geschlossenen Position verbunden sind.

2. Pixel nach Anspruch 1, wobei die Infrarotphotodiode (20) kein Silizium enthält.

3. Pixel nach Anspruch 1 oder 2, wobei die Infrarotphotodiode (20) aus einem Halbleiter auf der Grundlage von Materialien aus den Spalten IIIA und VA des Periodensystems hergestellt ist.

4. Pixel nach einem der Ansprüche 1 bis 3, wobei die Infrarotphotodiode (20) zwei Elektroden (20A, 20C) umfasst, wobei eine der beiden Elektroden (20A, 20C) an das Reservoir (21) angeschlossen ist.

5. Pixel nach einem der Ansprüche 1 bis 4, wobei der Bildgeber (12) ferner umfasst:
- einen zweiten Schalter (48), der zwischen der Infrarotphotodiode (20) und der eingebetteten Photodiode (29) angeschlossen ist.

6. Pixel nach Anspruch 5, wobei das Pixel (14) ferner umfasst:
- einen zweiten Diffusionsknoten (38), der zwischen der Infrarotphotodiode (20) und dem zweiten Schalter (48) angeschlossen ist,
wobei der zweite Schalter (48) zwischen einer offenen Position und einer geschlossenen Position bewegbar ist, wobei das Reservoir (21) und der zweite Diffusionsknoten (38) in der geschlossenen Position verbunden sind.

7. Pixel nach einem der Ansprüche 1 bis 3, wobei die Infrarotphotodiode (20) zwei Elektroden (20A, 20C) umfasst und der erste Schalter (26) einen Steuereingang (26G) des ersten Schalters (26) umfasst, wobei eine der beiden Elektroden (20A, 20C) der Infrarotphotodiode (20) an den Steuereingang (26G) des ersten Schalters (26) angeschlossen ist.

8. CMOS-Bildgeber (12), umfassend eine Vielzahl von Pixeln (14), wobei mindestens eines der Pixel (14) nach einem der Ansprüche 1 bis 7 ist.

9. CMOS-Bildgeber (12), umfassend eine Vielzahl von Pixeln (14), wobei jedes Pixel (14) nach einem der Ansprüche 1 bis 7 ist.

10. Kamera (10), umfassend mindestens einen CMOS-Bildgeber (12) nach Anspruch 8 oder 9.

## Claims

1. A pixel (14) of a CMOS imager, the pixel (14) comprising:
- an infrared photodiode (20) suitable for generating an electric current when it is exposed to an optical radiation having a wavelength greater than 950 nanometers (nm),
- a conversion circuit (28) able to receive electrons and to deliver a voltage with a value varying as a function of the number of received electrons,
- a first switch (26) connected between the infrared photodiode (20) and the conversion circuit (28),
- an electron reservoir (21), the electron reservoir (21) being a buried
photodiode (29),
- a first diffusion node (24) connected between the first switch (26) and the
conversion circuit (28),
**characterized in that**:
- the first switch (26) being movable between an open position and a closed
position, the reservoir (21) and the first diffusion node (24) being connected in the closed position.

2. The pixel according to claim 1, wherein the infrared photodiode (20) has no silicon.

3. The pixel according to claim 1 or 2, wherein the infrared photodiode (20) is made from a semiconductor made of materials belonging to the columns IIIA and VA of the periodic table.

4. The pixel according to any one of claims 1 to 3, wherein the infrared photodiode (20) comprises two electrodes (20A, 20C), one of the two electrodes (20A, 20C) being connected to the reservoir (21).

5. The method according to any one of claims 1 to 4, wherein the imager (12) further comprises:
- a second switch (48) connected between the infrared photodiode (20) and the buried photodiode (29).

6. The pixel according to claim 5, wherein the imager (14) further comprises:
- a second diffusion node (38) connected between the infrared photodiode (20) and the second switch (48),
the second switch (48) being movable between an open position and a closed position, the reservoir (21) and the second diffusion node (38) being connected in the closed position.

7. The pixel according to any one of claims 1 to 3, wherein the infrared photodiode (20) comprises two electrodes (20A, 20C) and the first switch (26) comprises a control input (26G) of the first switch (26), one of the two electrodes (20A, 20C) of the infrared photodiode (20) being connected to the control input (26G) of the first switch (26).

8. A CMOS imager (12) comprising a plurality of pixels (14), at least one of the pixels (14) being according to any one of claims 1 to 7.

9. A CMOS imager (12) comprising a plurality of pix els (14), each pixel (14) being according to any one of claims 1 to 7.

10. A camera (10) comprising at least one CMOS imager (12) according to claim 8 or 9.
